# EUROPEAN PATENT APPLICATION

(11) **EP 4 715 790 A1**
(43) Date of publication of application: **25.03.2026**
(21) Application number: 24829708.7
(22) Date of filing: 05.01.2024
(51) Int. Cl.: G09F 9/30

(54) **DISPLAY MODULE AND ELECTRONIC DEVICE**

(30) Priority: 30.06.2023 CN 202310808453
(71) Applicant: Huawei Technologies Co., Ltd., Shenzhen, Guangdong 518129 (CN)
(72) Inventor: ZHAO, Yaoxu, Shenzhen, Guangdong 518129 (CN); LI, Min, Shenzhen, Guangdong 518129 (CN); WANG, Wei, Shenzhen, Guangdong 518129 (CN); XU, Mingjie, Shenzhen, Guangdong 518129 (CN)
(74) Representative: Pfenning, Meinig & Partner mbB
(86) International application number: PCT/CN2024/070809
(87) International publication number: WO 2025/001045

(57) **Abstract**

A display module (11) and an electronic device that includes the display module (11) are provided, which relate to the field of display technologies. The display module (11) can improve unfolding stiffness and bendability. The display module (11) includes a display (112) and a cover plate (110) disposed on a display surface of the display (112). The display (112) includes at least two bending portions and three non-bending portions. In other words, the display module (11) is a multi-foldable display module (11), and the cover plate (110) is designed to be of an unequal-thickness structure. The cover plate (110) is designed as an unequal-thickness design, so that the non-bending portion has high rigidity, and the bending portion has good bendability.

## Description

This application claims priority to Chinese Patent Application No. 202310808453.6, filed with the China National Intellectual Property Administration on June 30, 2023 and entitled "DISPLAY MODULE AND ELECTRONIC DEVICE", which is incorporated herein by reference in its entirety.

### TECHNICAL FIELD

This application relates to the field of display technologies, and in particular, to a display module and a foldable electronic device that includes the display module.

### BACKGROUND

With the development of human-machine interaction technologies, displaying becomes an important element of human-machine interaction. Therefore, foldable electronic devices, for example, foldable mobile phones, emerge.

How to improve use performance of the foldable electronic devices is a main problem currently faced, for example, how to ensure good bendability of a bending area during bending, high unfolding stiffness of a non-bending area during unfolding, good impact resistance and compression resistance, and the like.

### SUMMARY

This application provides a display module and an electronic device that includes the display module, for example, a foldable electronic device. A main objective is to improve performance of the electronic device, for example, improve unfolding stiffness of a non-bending area and improve bendability of a bending area.

To achieve the foregoing objectives, the following technical solutions are used in embodiments of this application.

According to a first aspect, this application provides a display module. The display module is of a flexible display structure, may be used in a flexible display apparatus, and is bendable.

The display module includes a display and a cover plate. The cover plate is disposed on a display surface of the display. The display includes a first non-bending portion, a second non-bending portion, a third non-bending portion, a first bending portion, and a second bending portion. The first bending portion connects the first non-bending portion to the second non-bending portion. The second bending portion connects the second non-bending portion to the third non-bending portion. The cover plate includes a first non-bending area, a second non-bending area, a third non-bending area, a first bending area, and a second bending area. The first bending area connects the first non-bending area and the second non-bending area. The second bending area connects the second non-bending area and the third non-bending area. The first non-bending area corresponds to the first non-bending portion, the first bending area corresponds to the first bending portion, the second non-bending area corresponds to the second non-bending portion, the second bending area corresponds to the second bending portion, and the third non-bending area corresponds to the third non-bending portion. The first bending area, the first bending portion, the second bending area, and the second bending portion are all bendable along a bending line, to switch between an unfolded state and a closed state. The display module is of a display module structure that can be folded at least three times. A thickness of the first non-bending area of the cover plate is not equal to a thickness of the second non-bending area.

In the display module provided in this application, the thickness of the first non-bending area of the cover plate is not equal to the thickness of the second non-bending area of the cover plate. In other words, the cover plate is designed to be of an unequal-thickness structure. For example, in some scenarios, when the thickness of the first non-bending area is increased to improve stiffness of the first non-bending area exposed (which may present a picture to a user) in a closed state, an unequal-thickness design of the cover plate is used, so that bendability of the first bending area is basically not affected by an increase in the thickness of the first non-bending area.

In the display module provided in this application, the non-bending area may have high rigidity, and the bending area may have good bendability.

In a possible implementation, the thickness of the first non-bending area is greater than the thickness of the second non-bending area.

In some application scenarios, in the closed state, the first non-bending area is exposed. The thickness of the first non-bending area is greater than the thickness of the second non-bending area, so that stiffness of the first non-bending area is improved.

In a possible implementation, the cover plate includes a first substrate and a first cushion layer, and the first cushion layer is closer to the display than the first substrate. A thickness of the first substrate located in the first non-bending area is greater than a thickness of the first substrate located in the second non-bending area, and/or a thickness of the first cushion layer located in the first non-bending area is greater than a thickness of the first cushion layer located in the second non-bending area.

In some implementation structures, at least one of the substrate or the cushion layer in the cover plate may be designed to be of an unequal-thickness structure.

In a possible implementation, a thickness of the first cushion layer located in the first bending area gradually decreases in a direction from the first non-bending area to the second non-bending area.

In a possible implementation, the thickness of the first cushion layer located in the second non-bending area gradually decreases in a direction from the first bending area to the second bending area.

The thickness of the first cushion layer located in the first bending area and the second non-bending area gradually decreases, and a thick-thin transition area is designed to be wider, to better conceal a visual step difference of unequal thicknesses.

In a possible implementation, the first cushion layer is disposed on a surface that is of the first substrate and that faces the display.

Because the cushion layer is directly disposed on the surface of the substrate, an implementation structure of this application is different from some examples in which the cushion layer is bonded to the substrate via a bonding layer in that a thickness of the display module can be reduced.

In a possible implementation, a material of the first cushion layer includes at least one of a thermoplastic polyurethane elastomer, an organic silicone gel, and a shear thickening material.

In a possible implementation, the display module further includes a second substrate, the second substrate is disposed between the first cushion layer and the display, and the first cushion layer is disposed on a surface that is of the second substrate and that is away from the display.

In this example, the first substrate may be a substrate in a protective layer, and the second substrate may be a substrate in a display cover plate. If the protective layer and the display cover plate are disposed, the first cushion layer may be directly disposed on the surface of the second substrate of the display cover plate. The first cushion layer plays a cushioning function and a bonding role. Similar to using the bonding layer to bond the first cushion layer and the second substrate, this can compress a thickness of the display module.

In a possible implementation, a material of the first cushion layer includes an optically clear adhesive (OCA) or the like.

In a possible implementation, the cover plate further includes a second cushion layer, the second cushion layer includes a first portion and a second portion, the first portion of the second cushion layer is located in the first non-bending area, the second portion of the second cushion layer is located in the first bending area, and an elastic modulus of the first portion of the second cushion layer is greater than an elastic modulus of the second portion of the second cushion layer.

In some structures, the display module may further include the second cushion layer. To further improve bendability of the bending area, the second cushion layer may be designed to be of a structure with unequal elastic moduli. The second cushion layer in this example may be a cushion layer in the protective layer disposed on the display surface of the display, or may be a cushion layer in the display cover plate.

In a possible implementation, the second cushion layer is closer to the display than the first cushion layer; or the first cushion layer is closer to the display than the second cushion layer.

In a possible implementation, the first portion of the second cushion layer and the second portion of the second cushion layer are of an integrated structure; or the first portion of the second cushion layer and the second portion of the second cushion layer are connected to each other via a bonding layer.

For example, when the first portion and the second portion are of an integrated structure, the cushion layer material may be first coated on the substrate, and then area-based curing is performed on the cushion layer material through UV (ultraviolet) light, to obtain cushion materials with different hardnesses; or area-based heating may be performed on the cushion layer material, to obtain portions with different elastic moduli.

In a possible implementation, the second cushion layer further includes a third portion, and the third portion of the second cushion layer is located in the second non-bending area. An elastic modulus of the third portion of the second cushion layer is less than the elastic modulus of the first portion of the second cushion layer and greater than the elastic modulus of the second portion of the second cushion layer.

In a possible implementation, a thickness of the first bending area gradually decreases in the direction from the first non-bending area to the second non-bending area.

For the cover plate, the first non-bending area is a thick area, the second non-bending area is a thin area, and the first bending area connected between the first non-bending area and the second non-bending area is a thick-thin transition area.

In a possible implementation, the thickness of the second non-bending area gradually decreases in the direction from the first bending area to the second bending area.

The thickness of the first bending area and the second non-bending area of the cover plate gradually decreases, and the thick-thin transition area is designed to be wider, to better conceal a visual step difference of unequal thicknesses.

In a possible implementation, a thickness of the third non-bending area is less than the thickness of the first non-bending area.

In some scenarios, for disposing of a multi-foldable display, in the closed state, the first non-bending area is visible to a user, and the second non-bending area and the third non-bending area are invisible to the user. In this implementation structure, the cover plate includes a thick area of the first non-bending area and thin areas of the second non-bending area and the third non-bending area, to meet a rigidity requirement of an electronic device in this scenario, and does not excessively increase a thickness of the display module in the closed state.

In a possible implementation, the thickness of the first bending area, the thickness of the second non-bending area, a thickness of the second bending area, and the thickness of the third non-bending area gradually decrease in a direction from the first non-bending area to the third non-bending area.

A visual step difference of unequal thicknesses is further concealed.

In a possible implementation, the display module further includes a support plate and a cushion. The support plate is disposed on one side that is of the display and that is away from the display surface. The cushion is disposed on one side that is of the support plate and that is away from the display, and the cushion is located at a position corresponding to the first bending area.

In a possible implementation, the display module further includes a support plate and a cushion. The support plate is disposed on one side that is of the display and that is away from the display surface. The cushion is embedded in a position that is of the support plate and that corresponds to the first bending area.

In some examples, to ensure bendability of the bending area, impact resistance and compression resistance performance of the bending portion is weakened. In this example of this application, the cushion is disposed at a part that is of the support plate and that corresponds to the first bending area, so that a cushion characteristic of the cushion can be used to improve impact resistance and compression resistance performance of the area. For example, the cushion may be disposed on one side that is of the support plate and that is away from the display, or the cushion may be embedded in the support plate.

In a possible implementation, when the first bending area is in the closed state, the display surface of the display is away from a center of an arc-shaped structure formed by the display module, relative to a back surface of the display, so that the first bending area forms an outward bending structure.

When the electronic device is in the closed state, a picture of the first non-bending area is visible to the user. This example of this application may alternatively be applied to a case in which the picture of the first non-bending area is invisible to the user.

In a possible implementation, when the second bending area is in the closed state, the display surface of the display is close to a center of an arc-shaped structure formed by the display module, relative to a back surface of the display, so that the second bending area forms an inward bending structure; and when the first bending area is in the closed state, the display surface of the display is away from the center of the arc-shaped structure formed by the display module, relative to the back surface of the display, so that the first bending area forms an outward bending structure.

In some embodiments of this application, when the electronic device is in the closed state, one outward folded area and one inward folded area are formed.

According to a second aspect, this application provides a display module. The display module includes a display and a cover plate. The cover plate is disposed on a display surface of the display. The display includes a first non-bending portion, a second non-bending portion, a third non-bending portion, a first bending portion, and a second bending portion. The first bending portion connects the first non-bending portion to the second non-bending portion. The second bending portion connects the second non-bending portion and the third non-bending portion. The cover plate includes a first non-bending area, a second non-bending area, a third non-bending area, a first bending area, and a second bending area. The first bending area connects the first non-bending area and the second non-bending area. The second bending area connects the second non-bending area and the third non-bending area. The first non-bending area corresponds to the first non-bending portion, the first bending area corresponds to the first bending portion, the second non-bending area corresponds to the second non-bending portion, the second bending area corresponds to the second bending portion, and the third non-bending area corresponds to the third non-bending portion. The first bending area, the first bending portion, the second bending area, and the second bending portion are all bendable along a bending line, to switch between an unfolded state and a closed state. This application is a display that can be bent at least three times; and an elastic modulus of the first non-bending area is not equal to an elastic modulus of the first bending area.

In the display module provided in this application, the cover plate disposed on the display surface of the display is designed to be of an unequal-modulus structure. For example, the elastic modulus of the first non-bending area may be greater than the elastic modulus of the first bending area. In this way, it is ensured that the first non-bending area has high rigidity, and the first bending area can have good bendability.

In a possible implementation, the elastic modulus of the first non-bending area is greater than the elastic modulus of the first bending area.

In some use scenarios, in a closed state, the first non-bending area is exposed, and the elastic modulus of the first non-bending area is greater than the elastic modulus of the first bending area, so that stiffness of the first non-bending area is improved and bendability of the first bending area is ensured.

In a possible implementation, the cover plate includes a substrate and a cushion layer. The substrate and the cushion layer are disposed on the display surface of the display, and the cushion layer is closer to the display than the substrate. The cushion layer includes a first portion and a second portion. The first portion of the cushion layer is located in the first non-bending area, the second portion of the cushion layer is located in the first bending area, and an elastic modulus of the first portion of the cushion layer is greater than an elastic modulus of the second portion of the cushion layer.

In a possible implementation, the first portion of the cushion layer and the second portion of the cushion layer are of an integrated structure; or the first portion of the cushion layer and the second portion of the cushion layer are connected to each other via a bonding layer.

In some embodiments of this application, two implementations in which the cover plate has unequal moduli are provided. Certainly, another implementation may alternatively be used.

In a possible implementation, the cushion layer further includes a third portion, and the third portion of the cushion layer is located in the second non-bending area. An elastic modulus of the third portion of the cushion layer is less than the elastic modulus of the first portion of the cushion layer and greater than the elastic modulus of the second portion of the cushion layer.

In a possible implementation, the display module further includes a support plate and a cushion. The support plate is disposed on one side that is of the display and that is away from the display surface. The cushion is disposed on one side that is of the support plate and that is away from the display, and the cushion is located at a position corresponding to the first bending area.

In a possible implementation, the display module further includes a support plate and a cushion. The support plate is disposed on one side that is of the display and that is away from the display surface. The cushion is embedded in a position that is of the support plate and that corresponds to the first bending area.

In some examples, to ensure bendability of the bending area, impact resistance and compression resistance performance of the bending portion is weakened. In this example of this application, the cushion is disposed at a part that is of the support plate and that corresponds to the first bending area, so that a cushion characteristic of the cushion can be used to improve impact resistance and compression resistance performance of the area. For example, the cushion may be disposed on one side that is of the support plate and that is away from the display, or the cushion may be embedded in the support plate.

In a possible implementation, when the first bending area is in the closed state, the display surface of the display is away from a center of an arc-shaped structure formed by the display module, relative to a back surface of the display, so that the first bending area forms an outward bending structure.

In other words, when an electronic device is in the closed state, a picture of the first non-bending area is visible to a user. This application may alternatively be applied to a case in which the picture of the first non-bending area is invisible to the user.

In a possible implementation, when the second bending area is in the closed state, the display surface of the display is close to a center of an arc-shaped structure formed by the display module, relative to a back surface of the display, so that the second bending area forms an inward bending structure; and when the first bending area is in the closed state, the display surface of the display is away from the center of the arc-shaped structure formed by the display module, relative to the back surface of the display, so that the first bending area forms an outward bending structure.

In some embodiments of this application, when the displayed electronic device is in the closed state, one outward folded area and one inward folded area are formed.

According to a third aspect, this application further provides an electronic device that includes a housing and the display module in any one of the foregoing implementations. The display module is disposed on the housing.

The electronic device provided in embodiments of this application includes the foregoing display module. Therefore, the electronic device provided in embodiments of this application and the display module in the foregoing technical solutions can resolve a same technical problem and achieve same expected effect.

### BRIEF DESCRIPTION OF DRAWINGS

FIG. 1 is a diagram of a structure of a foldable electronic device;
FIG. 2 is a diagram of a structure of a multi-foldable display module in an unfolded state;
FIG. 3 is a diagram of a structure of a multi-foldable display module in an unfolded state according to an embodiment of this application;
FIG. 4 is a diagram of a structure of a multi-foldable display module in an unfolded state according to an embodiment of this application;
FIG. 5 is a diagram of a structure of a multi-foldable display module in an unfolded state according to an embodiment of this application;
FIG. 6 is a diagram of a structure of a multi-foldable display module in a closed state according to an embodiment of this application;
FIG. 7 is a diagram of a structure of a multi-foldable display module in an unfolded state according to an embodiment of this application;
FIG. 8 is a diagram of a structure of a multi-foldable display module in an unfolded state according to an embodiment of this application;
FIG. 9 is a diagram of a structure of a multi-foldable display module in an unfolded state according to an embodiment of this application;
FIG. 10 is a diagram of a structure of a multi-foldable display module according to an embodiment of this application;
FIG. 11 is a diagram of a structure of a cover plate in a multi-foldable display module in an unfolded state according to an embodiment of this application;
FIG. 12 is a diagram of a structure of a cover plate in a multi-foldable display module in an unfolded state according to an embodiment of this application;
FIG. 13 is a diagram of a structure of a cover plate in a multi-foldable display module in an unfolded state according to an embodiment of this application;
FIG. 14 is a diagram of a structure of a cover plate in a multi-foldable display module in an unfolded state according to an embodiment of this application;
FIG. 15 is a diagram of a structure of a cover plate in a multi-foldable display module in an unfolded state according to an embodiment of this application;
FIG. 16 is a diagram of a structure of a cover plate in a multi-foldable display module in an unfolded state according to an embodiment of this application;
FIG. 17 is a diagram of a structure of a multi-foldable display module in an unfolded state according to an embodiment of this application;
FIG. 18 is a diagram of a structure of a cover plate in a multi-foldable display module in an unfolded state according to an embodiment of this application;
FIG. 19 is a diagram of a structure of a cover plate in a multi-foldable display module in an unfolded state according to an embodiment of this application;
FIG. 20 is a diagram of a structure of a cover plate in a multi-foldable display module in an unfolded state according to an embodiment of this application;
FIG. 21 is a diagram of a structure of a multi-foldable display module in an unfolded state according to an embodiment of this application;
FIG. 22 is a diagram of a structure of a multi-foldable display module in an unfolded state according to an embodiment of this application;
FIG. 23 is a diagram of a structure of a multi-foldable display module in an unfolded state according to an embodiment of this application;
FIG. 24 is a diagram of a structure of a multi-foldable display module in an unfolded state according to an embodiment of this application; and
FIG. 25 is a diagram of a structure of a multi-foldable display module in an unfolded state according to an embodiment of this application.

### DESCRIPTION OF EMBODIMENTS

The following describes in detail specific embodiments of this application with reference to the accompanying drawings.

Embodiments of this application provide an electronic device having a foldable screen. The electronic device may include an electronic product having a display function, such as a mobile phone (mobile phone), a tablet computer (pad), an intelligent wearable product (for example, a smartwatch or a smart band), a virtual reality (virtual reality, VR) terminal device, or an augmented reality (augmented reality, AR) terminal device. A specific form of the electronic device having the display function is not specially limited in embodiments of this application.

For ease of description, the following describes a structure of the electronic device by using an example in which the electronic device is a mobile phone.

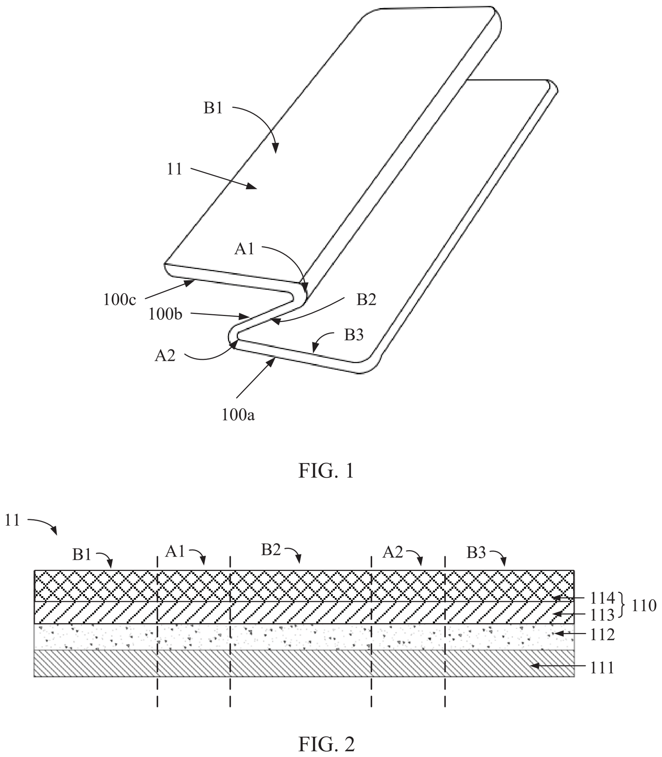

FIG. 1 is a diagram of a structure of a foldable mobile phone. In addition, for example, the foldable mobile phone is a triple-screen foldable mobile phone. The triple-screen foldable mobile phone may include a first housing 100a, a second housing 100b, a third housing 100c, and a display module 11. The display module 11 may continuously cover the first housing 100a, the second housing 100b, and the third housing 100c. The foldable mobile phone may further include a first hinge mechanism and a second hinge mechanism.

The first housing 100a and the second housing 100b are disposed on two sides of the first hinge mechanism, and are separately connected to the first hinge mechanism. The first hinge mechanism is movable, so that the first housing 100a and the second housing 100b are folded or unfolded relative to each other, to unfold or close the display module 11 disposed on the first housing 100a and the second housing 100b.

The second housing 100b and the third housing 100c are disposed on two sides of the second hinge mechanism, and are separately connected to the second hinge mechanism. The second hinge mechanism is movable, so that the second housing 100b and the third housing 100c are folded or unfolded relative to each other, to unfold or close the display module 11 disposed on the second housing 100b and the third housing 100c.

The foldable electronic device may be unfolded to be in an unfolded state, or may be folded to be in a closed state, or may be in an intermediate state between the unfolded state and the closed state. The foldable electronic device has at least two states: the unfolded state and the closed state. In some cases, the foldable electronic device may further include a third state, namely, the intermediate state between the unfolded state and the closed state. The intermediate state is not a unique state, and may be any one or more states between the unfolded state and the closed state of the electronic device.

FIG. 1 shows an example of a triple-screen foldable electronic device. The electronic device in embodiments of this application may alternatively be a device with more screens, for example, a quadra-screen foldable electronic device or a penta-screen foldable electronic device.

In a foldable electronic device, multi-folding is increasingly favored by users, for example, the triple-foldable electronic device shown in FIG. 1. When the electronic device is in the folded (or closed) state, as shown in FIG. 1, a non-bending area B1 of the display module is exposed. To improve a capability of the exposed non-bending area to resist external force damage, a thickness of the non-bending area B1 may be increased to improve stiffness and strength.

As shown in FIG. 2, the display module 11 may include a support plate (bracket) 111, a display (panel) 112, and a cover plate 110.

The support plate 111 and the cover plate 110 are disposed on two opposite sides of the display 112. The support plate 111 is located on a back surface of the display 112, and is configured as a support structure to support the display 112. The cover plate 110 is located on a display surface of the display 112, and is configured to protect the display 112, to reduce a probability that the display 112 is damaged.

The display surface of the display 112 is one surface that is of the display 112 and that is configured to display a picture to the user. The back surface of the display 112 is one surface opposite to the display surface of the display 112. The back surface of the display 112 may alternatively be one surface away from the display surface.

As shown in FIG. 2, film layer structures in the display module 11 are connected to each other and form a sheet-shaped integrated structure. For example, a protective layer 114 in the cover plate 110 is of a continuous integrated structure in non-bending areas and bending areas, and a thickness in each area is the same. Similarly, a thickness of a display cover plate 113 in the cover plate 110 in each area is the same. When a thickness of the non-bending area B1 in the display module needs to be increased, thicknesses of other areas (for example, a bending area A1, a non-bending area B2, a bending area A2, and a non-bending area B3) are also correspondingly increased. As a result, a thickness of the entire device is large in the closed state.

Even if a thickness of the display module 11 is increased to improve stiffness of the non-bending area B1, a thick screen body affects bendability of the bending area A1 and the bending area A2, increases rebound forces of the bending area A1 and the bending area A2, and reduces user experience.

This application provides some embodiments of the display module, to improve stiffness of an exposed non-bending area without weakening bendability of a bending area.

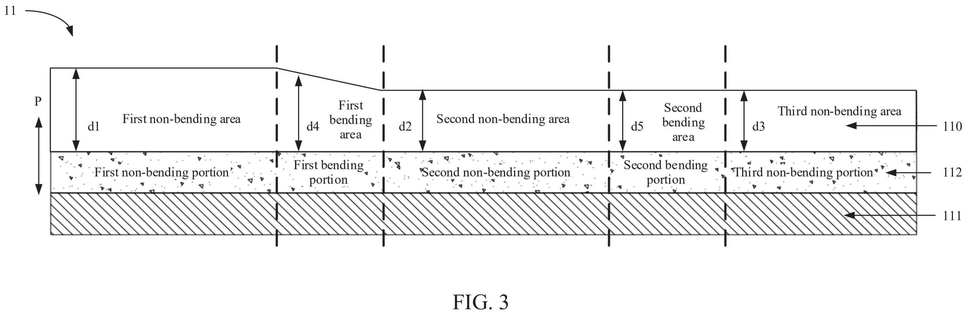

FIG. 3 is a diagram of a structure of a display module according to an embodiment of this application. The display module 11 includes a support plate (bracket) 111, a display (panel) 112, and a cover plate 110. The support plate 111 and the cover plate 110 are disposed on two opposite sides of the display 112. The support plate 111 is located on a back surface of the display 112, and is configured as a support structure to support the display 112. The cover plate 110 is located on a display surface of the display 112, and is configured to protect the display 112.

The display 112 in the display module 11 includes a first non-bending portion, a second non-bending portion, a third non-bending portion, a first bending portion, and a second bending portion. The first bending portion connects the first non-bending portion and the second non-bending portion, and the second bending portion connects the second non-bending portion and the third non-bending portion.

The cover plate 110 in the display module 11 includes a first non-bending area, a second non-bending area, a third non-bending area, a first bending area connecting the first non-bending area and the second non-bending area, and a second bending area connecting the second non-bending area and the third non-bending area.

The first non-bending portion of the display 112 corresponds to the first non-bending area of the cover plate 110, the first bending portion of the display 112 corresponds to the first bending area of the cover plate 110, the second non-bending portion of the display 112 corresponds to the second non-bending area of the cover plate 110, the second bending portion of the display 112 corresponds to the second bending area of the cover plate 110, and the third non-bending portion of the display 112 corresponds to the third non-bending area of the cover plate 110.

The first bending area, the first bending portion, the second bending area, and the second bending portion are all bendable along a bending line, to switch between an unfolded state and a closed state.

FIG. 3 uses triple-screen folding as an example. In some other examples, more bending areas and non-bending areas may be added based on the structure shown in FIG. 3, to form a quadra-screen foldable electronic device, a penta-screen foldable electronic device, or the like.

As shown in FIG. 3, a thickness of the first non-bending area of the cover plate 110 is d1, a thickness of the second non-bending area of the cover plate 110 is d2, and the thickness d1 is not equal to the thickness d2. For example, the thickness d1 may be greater than the thickness d2.

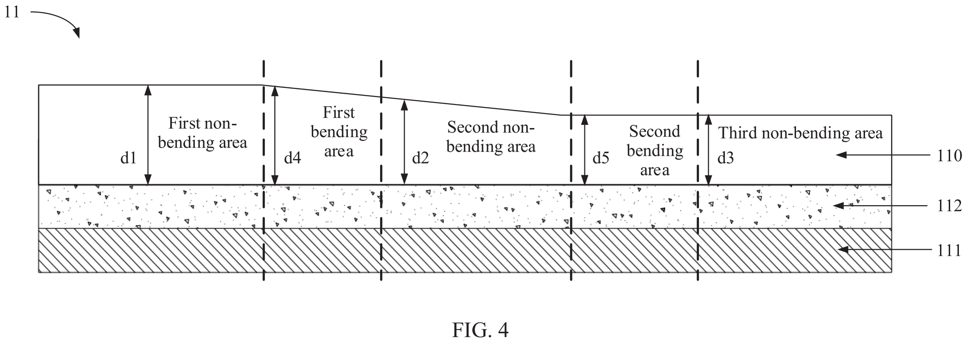

FIG. 4 is a diagram of a structure of another display module according to an embodiment of this application. Similar to those in FIG. 3, the thickness of the first non-bending area of the cover plate 110 is d1, the thickness of the second non-bending area of the cover plate 110 is d2, the thickness d1 is not equal to the thickness d2, and the thickness d1 is greater than the thickness d2.

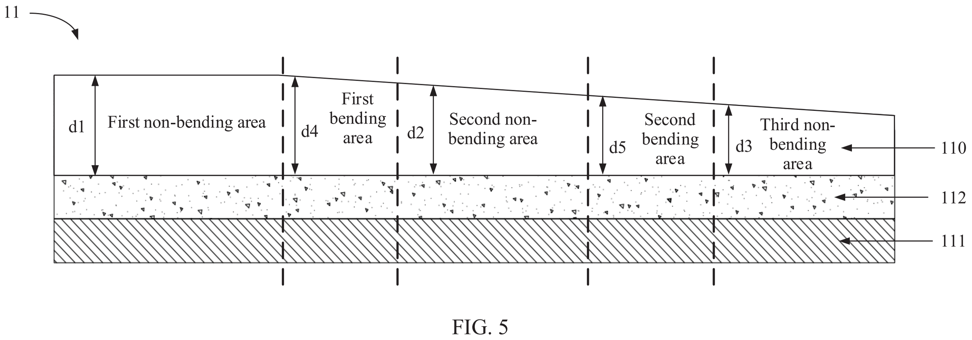

FIG. 5 is a diagram of a structure of still another display module according to an embodiment of this application. Similar to those in FIG. 3 and FIG. 4, for the cover plate 110, the thickness d1 of the first non-bending area is not equal to the thickness d2 of the second non-bending area, and the thickness d1 is greater than the thickness d2.

In some examples, the thickness in embodiments of this application is a dimension along a direction (a direction P) in which a plurality of film layers are stacked as shown in FIG. 3.

In the three different examples of the display module 11 shown in FIG. 3, FIG. 4, and FIG. 5, a thickness d4 of the first bending area of the cover plate 110 is not constant. Instead, the thickness d4 gradually decreases in a direction away from the first non-bending area, which may be a direction from the first non-bending area to the second non-bending area, so that the thickness d2 is less than the thickness d1.

As shown in FIG. 3 to FIG. 5, for the cover plate 110, the first non-bending area is a thick area, the second non-bending area is a thin area, and the first bending area connected between the first non-bending area and the second non-bending area is a thick-thin transition area.

Differences between the three different examples of the display module 11 shown in FIG. 3, FIG. 4, and FIG. 5 include the following:

For the cover plate 110 in FIG. 3, a thickness of the second bending area is d5, a thickness of the third non-bending area is d3, and the thickness d2, the thickness d5, and the thickness d3 are equal. The first non-bending area is a thick area, the first bending area is a thick-thin transition area, and the second non-bending area, the second bending area, and the third non-bending area are thin areas with equal thicknesses.

Compared with those in FIG. 3, in an example shown in FIG. 4, the thickness d4 of the first bending area is not a constant value, and the thickness d2 of the second non-bending area is also not a constant value. In some examples, the thicknesses of the first bending area and the second non-bending area of the cover plate 110 gradually decrease in the direction away from the first non-bending area, so that visual effect of uneven thickness of the entire display module can be mitigated.

In FIG. 4, the thickness of the second bending area of the cover plate 110 is equal to the thickness of the third non-bending area of the cover plate 110. In other words, the thickness d5 is equal to the thickness d3.

In FIG. 4, the first non-bending area is a thick area, the first bending area and the second non-bending area are thick-thin transition areas, and the second bending area and the third non-bending area are thin areas with equal thicknesses.

Compared with those in FIG. 3 and FIG. 4, in FIG. 5, the thicknesses of the first bending area and the second non-bending area of the cover plate 110 are not constant values, and the thicknesses of the second bending area and the third non-bending area of the cover plate 110 are also not constant values. The thicknesses of the first bending area, the second non-bending area, the second bending area, and the third non-bending area of the cover plate 110 gradually decrease in the direction away from the first non-bending area, so that the visual effect of uneven thickness of the entire display module can be further mitigated.

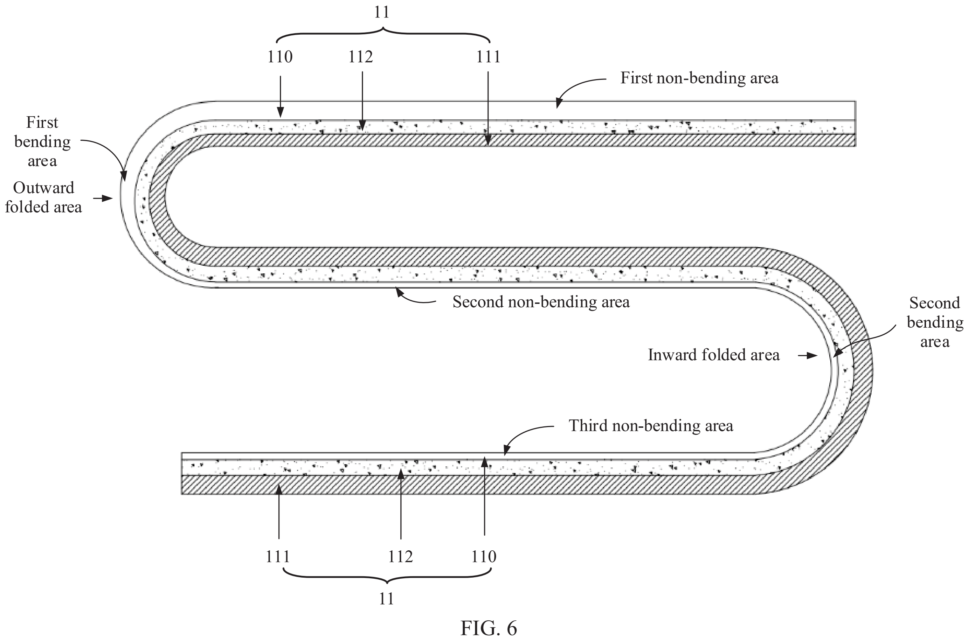

FIG. 6 is a diagram of a structure of the bent display module 11 in this embodiment of this application in FIG. 3. A thickness of an exposed first non-bending area (visible to a user during folding) is greater than a thickness of a non-exposed second non-bending area (invisible to the user during folding). The first bending area connected to the exposed first non-bending area is designed to be of an unequal-thickness structure. To improve stiffness and strength of the first non-bending area, the thickness of the first non-bending area is increased, which does not affect bendability of a bending area. A thickness of another area is not increased, and when an entire device is in the folded state, a thickness in the closed state is not significantly increased.

In some examples, the bending area shown in FIG. 3 to FIG. 5 may form an inward folded area, or may form an outward folded area. For example, in the closed state shown in FIG. 6, the first bending area forms an outward folded area, and the second bending area forms an inward folded area. The first non-bending area is exposed, and is visible to the user. The second non-bending area and the third non-bending area are opposite to each other, and are invisible to the user.

As shown in FIG. 6, the outward folded area is an area in which a display picture is still visible to the user in a folding process and the closed state of the display module 11, and the user may further perform some operations on the display module 11 in the closed state. Alternatively, the display surface of the display module 11 may be visible to the user.

As shown in FIG. 6, the inward folded area is an area in which a display picture is located on an inner side of the electronic device in a process in which the electronic device is switched from the unfolded state to the closed state and in the closed state of the electronic device. In other words, the display picture gradually becomes invisible to the user in the folding process until the display module 11 is completely hidden between two housings in the closed state. The display surface of the display module 11 is hidden and invisible to the user.

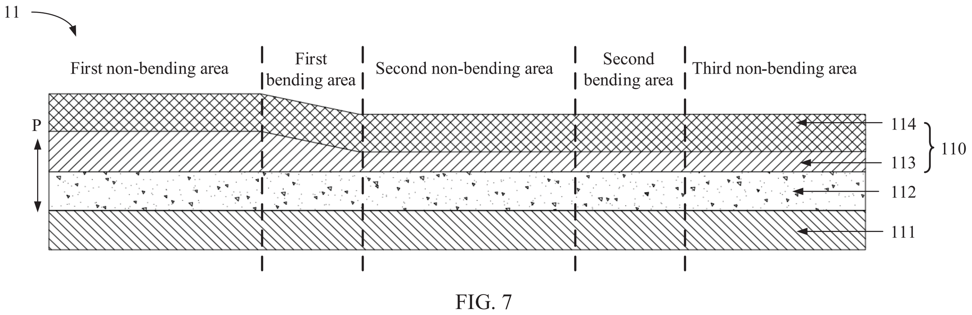

As shown in FIG. 7, FIG. 7 is a diagram of a structure of a display module according to an embodiment of this application. The cover plate 110 may include the display cover plate 113 and the protective layer 114. The display cover plate 113 is disposed on the display surface of the display 112, and the protective layer 114 is disposed on one side that is of the display cover plate 113 and that is away from the display 112. Both the display cover plate 113 and the protective layer 114 are transparent. Light transmitted through the display surface of the display 112 may pass through the display cover plate 113 and the protective layer 114, and be received by the user.

In some application scenarios, when the protective layer 114 is damaged or falls off, the display cover plate 113 may still be used to protect the display 112.

Certainly, in some other examples, the cover plate 110 may further include another film layer structure, or the cover plate 110 includes one of the display cover plate 113 and the protective layer 114.

In this embodiment of this application, the display (panel) 112 may be a flexible display, and the cover plate 110 may be of a flexible structure, to meet a folding requirement.

The display 112 can be configured to display information and provide an interaction interface for the user. In embodiments of this application, the display 112 may be but is not limited to an organic light-emitting diode (organic light-emitting diode, OLED) display, an active-matrix organic light-emitting diode (active-matrix organic light-emitting diode, AMOLED) display, a mini light-emitting diode (mini organic light-emitting diode) display, a micro light-emitting diode (micro organic light-emitting diode) display, a micro organic light-emitting diode (micro organic light-emitting diode) display, a quantum dot light-emitting diode (quantum dot light-emitting diode, QLED) display, or the like. In an example shown in FIG. 7, a thickness of the display cover plate 113 located in the first non-bending area is greater than a thickness of the display cover plate located in the second non-bending area, and the thickness of the display cover plate 113 located in the first bending area gradually decreases in the direction away from the first non-bending area.

In FIG. 7, thicknesses of the protective layer 114 in bending areas and non-bending areas are equal.

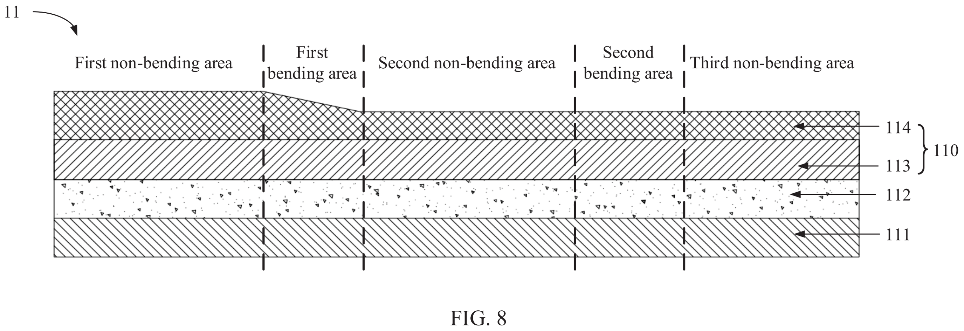

FIG. 8 is a diagram of a structure of still another display module according to an embodiment of this application. In this structure, a thickness of the protective layer 114 located in the first non-bending area is greater than a thickness of the protective layer located in the second non-bending area, and a thickness of the protective layer 114 located in the first bending area gradually decreases in the direction away from the first non-bending area.

In FIG. 8, thicknesses of the display cover plate 113 in bending areas and non-bending areas are equal.

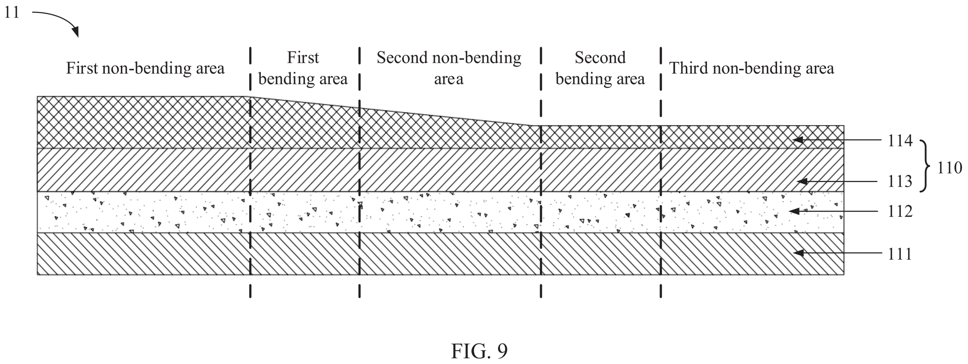

FIG. 9 is a diagram of a structure of still another display module according to an embodiment of this application. Compared with those in FIG. 8, in this structure, along the direction away from the first non-bending area, the thicknesses of the first bending area and the second non-bending area in the protective layer 114 gradually decrease, and a width of a thick-thin transition area of the protective layer 114 is widened.

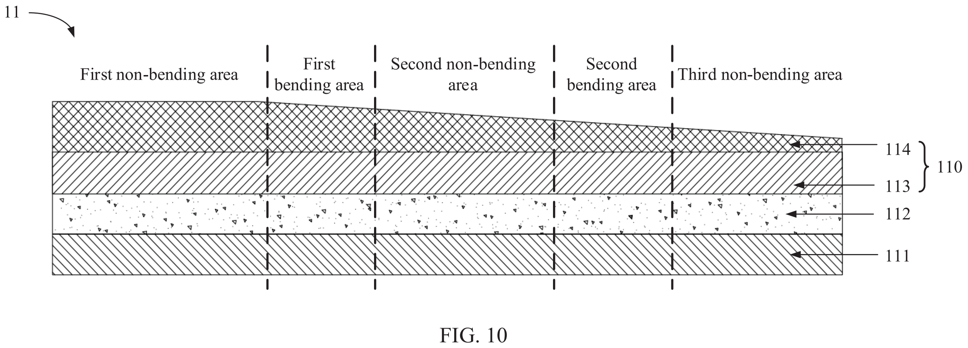

FIG. 10 is a diagram of a structure of yet still another display module according to an embodiment of this application. Compared with those in FIG. 8 and FIG. 9, in this example, in the protective layer 114, along the direction away from the first non-bending area, the thicknesses of the first bending area, the second non-bending area, the second bending area, and the third non-bending area gradually decrease, and a width of a thick-thin transition area of the protective layer 114 is further widened.

In FIG. 8 to FIG. 10, an example in which the protective layer 114 is designed to be of an unequal-thickness structure is used. In some other examples, the thick-thin transition area with an uneven thickness may be disposed in another film layer structure. For example, in the display cover plate 113, the structures shown in FIG. 8 to FIG. 10 may also be used.

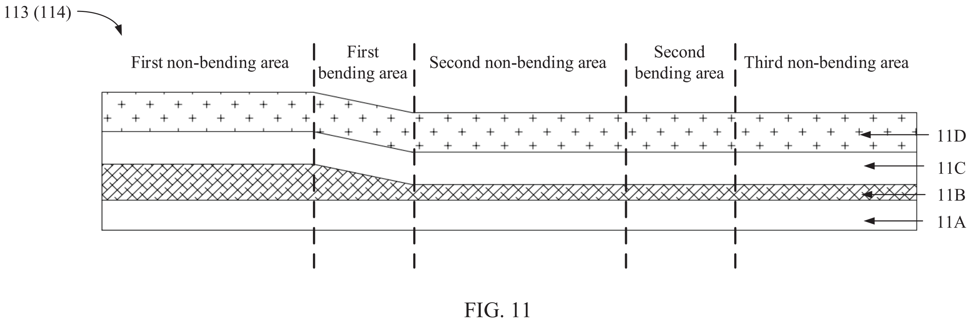

In some examples provided in this application, as shown in FIG. 11, the display cover plate 113 or the protective layer 114 may include a substrate 11D and a cushion layer 11B.

The substrate 11D and the cushion layer 11B may be connected via a bonding layer 11C, and a bonding layer 11A connects these stacked film layer structures and another layer structure. In some examples, when the protective layer 114 is shown in FIG. 11, a structure including the substrate 11D, the bonding layer 11C, and the cushion layer 11B may be connected to the display cover plate 113 via the bonding layer 11A.

In some optional materials, the substrate 11D may be made of at least one of polyethylene terephthalate (polyethylene terephthalate, PET), polyimide (polyimide, PI), and transparent polyimide (CPI).

In some examples, the cushion layer 11B is made of an elastomer film material, and an elastic modulus of the cushion layer 11B is less than an elastic modulus of the substrate 11D. The cushion layer 11B may be made of at least one of elastomer film materials such as a thermoplastic polyurethane (TPU) elastomer and a thermoplastic polyamide elastomer (TPAE).

The bonding layer 11A and the bonding layer 11C may be made of at least one of optically clear adhesive (optically clear adhesive, OCA), optically clear resin (optically clear resin, OCR), acrylic resin, epoxy resin, and the like.

Refer to FIG. 11. In this embodiment, the cushion layer 11B located in the first bending area is designed to be of an unequal-thickness structure. A thickness of the cushion layer 11B located in the first bending area gradually decreases in the direction away from the first non-bending area, so that the protective layer 114 or the display cover plate 113 located in the first bending area is in a thick-thin transition area.

In FIG. 11, a thickness of the substrate 11D may range from 25 µm to 75 µm. Thicknesses of the bonding layer 11A and the bonding layer 11C may range from 25 µm to 50 µm.

A thickness of the cushion layer 11B located in the first non-bending area ranges from 75 µm to 150 µm, and thicknesses of the cushion layer 11B located in the second non-bending area, the second bending area, and the third non-bending area range from 25 µm to 75 µm.

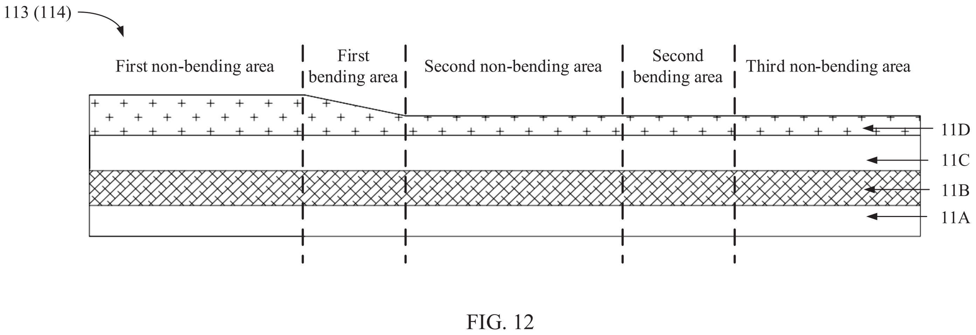

FIG. 12 is a diagram of a structure of another display cover plate 113 or protective layer 114 according to an embodiment of this application. In this example, the substrate 11D located in the first bending area is designed to be of an unequal-thickness structure. A thickness of the substrate 11D located in the first bending area gradually decreases in the direction away from the first non-bending area, so that the protective layer 114 or the display cover plate 113 located in the first bending area is in a thick-thin transition area.

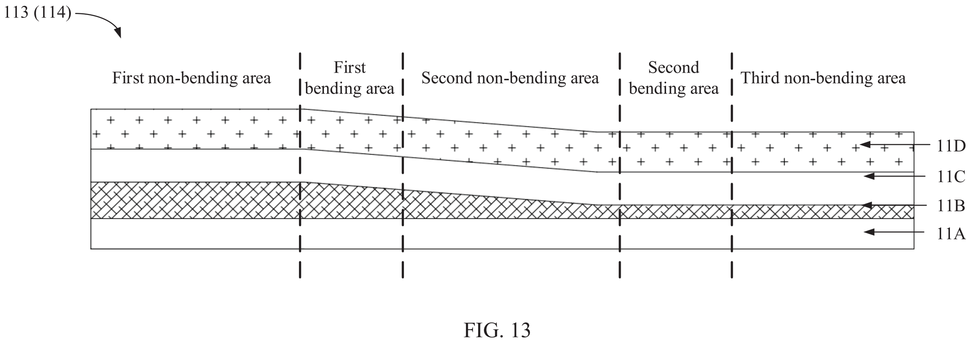

FIG. 13 is a diagram of a structure of still another display cover plate 113 or protective layer 114 according to an embodiment of this application. Compared with those in FIG. 12, the cushion layer 11B located in the first bending area is designed to be of an unequal-thickness structure, and the cushion layer 11B located in the second non-bending area is also designed to be of an unequal-thickness structure, so that visual effect of uneven thickness of an entire display module can be mitigated.

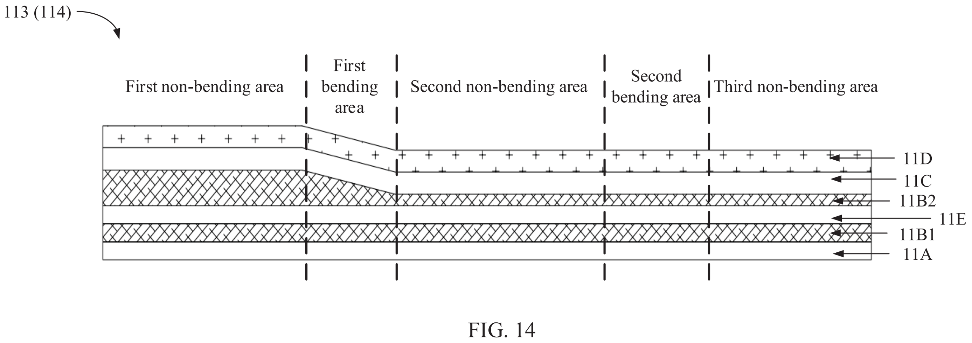

FIG. 14 is a diagram of a structure of yet still another display cover plate 113 or protective layer 114 according to an embodiment of this application. In some examples, a thickness of the cushion layer 11B is large. For example, the thickness reaches 100 µm. Because the cushion layer is thick, strain generated on an upper surface and a lower surface of a film material when the display module is bent helps easily enter a plastic deformation phase.

When the display module is bent, to weaken the strain generated on the upper surface and the lower surface of the display module and enter the plastic deformation phase, bendability is improved. In some examples, as shown in FIG. 14, the cushion layer 11B includes a first cushion layer 11B1 and a second cushion layer 11B2. The first cushion layer 11B1 is of an equal-thickness structure, and the second cushion layer 11B2 located in the first bending area is designed to be of an unequal-thickness structure. Compared with the first cushion layer 11B1 with an even thickness, the second cushion layer 11B2 with an uneven thickness is farther away from the display, that is, closer to an interface visible to the user. In some other examples, the first cushion layer 11B1 with an even thickness may alternatively be closer to the interface visible to the user than the second cushion layer 11B2 with an uneven thickness.

Refer to FIG. 14. The first cushion layer 11B1 is connected to the second cushion layer 11B2 via a bonding layer 11E, and the second cushion layer 11B2 is connected to the substrate 11D via a bonding layer 11C.

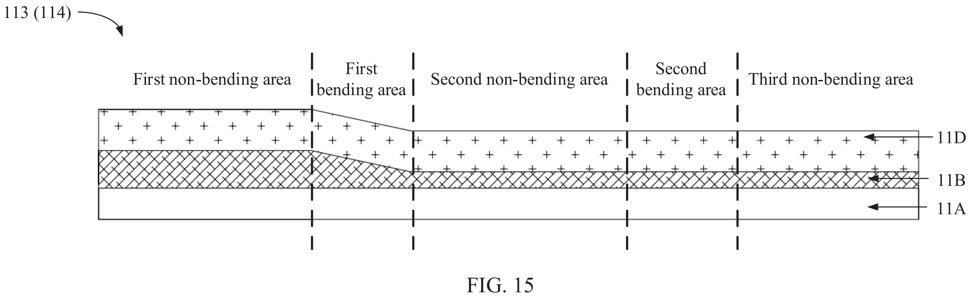

FIG. 15 is a diagram of a structure of still another display cover plate 113 or protective layer 114 according to an embodiment of this application. In some optional processes, the cushion layer 11B and the substrate 11D may be bonded together by using a coating process. A bonding layer configured to connect the cushion layer 11B and the substrate 11D may be removed, to reduce a thickness of an entire display module, without weakening stiffness of non-bending areas and bendability of bending areas.

A material of the cushion layer 11B in the example in FIG. 15 may be at least one of a thermoplastic polyurethane elastomer, an organic silicone gel, and a shear thickening material.

Refer to FIG. 15. In the example, the cushion layer 11B located in the first bending area is designed to be of an unequal-thickness structure, and thicknesses of the substrate 11D in all areas are equal.

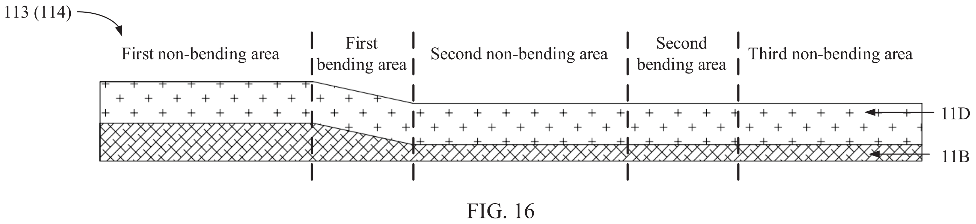

FIG. 16 is a diagram of a structure of still another display cover plate 113 or protective layer 114 according to an embodiment of this application. In some optional processes, the cushion layer 11B and the substrate 11D may be bonded together by using a coating process. In the example, the cushion layer 11B may be made of an adhesive material, for example, an optically clear adhesive (OCA). The cushion layer 11B is not only an elastomer film material, but also has a connection function, and the bonding layer 11A may not be required. Therefore, a thickness of a display module may be further compressed.

Refer to FIG. 16. In the example, the cushion layer 11B located in the first bending area is designed to be of an unequal-thickness structure, and thicknesses of the substrate 11D in all areas are equal.

To improve stiffness of an exposed non-bending area without weakening bendability of a bending area, embodiments of this application further provide some implementable structures. Details are as follows:

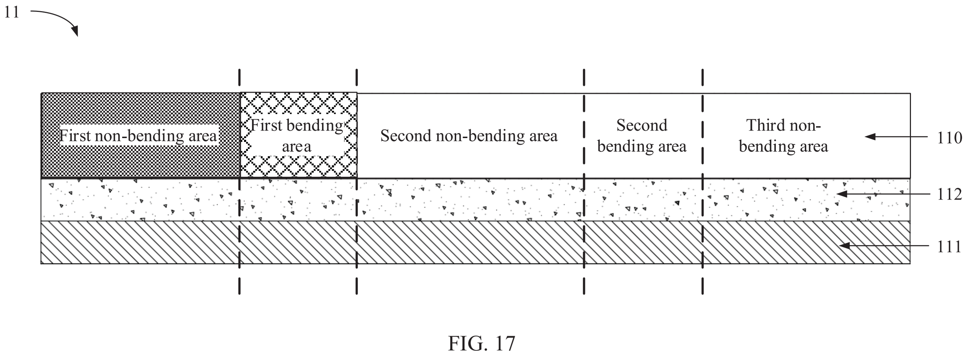

FIG. 17 is a diagram of a structure of a display module according to an embodiment of this application. For the cover plate 110 of the display module 11, an elastic modulus located in the first non-bending area is greater than an elastic modulus located in the first bending area. The cover plate 110 includes a hard area with a large elastic modulus and a soft area with a small elastic modulus.

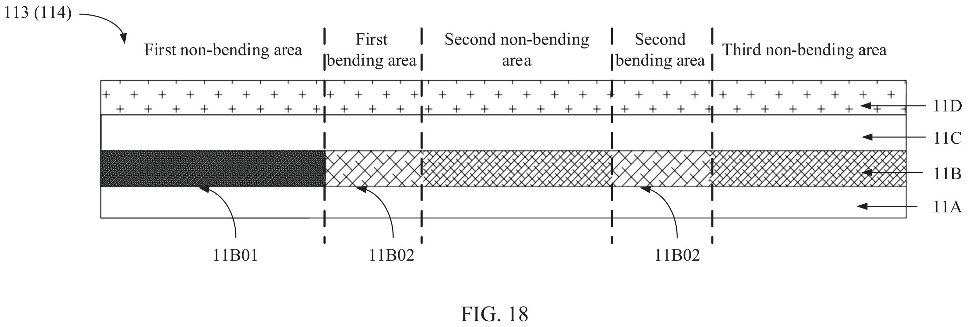

In some examples, when the cover plate 110 includes the display cover plate or the protective layer, the hard area and the soft area may be disposed in at least one of the display cover plate and the protective layer. For example, FIG. 18 is a diagram of a structure of a display cover plate 113 or protective layer 114 according to an embodiment of this application. The substrate 11D and the cushion layer 11B are included, and the substrate 11D and the cushion layer 11B are connected to each other via the bonding layer 11C.

As shown in FIG. 18, the cushion layer 11B includes a hard area 11B01 (which may also be referred to as a first portion) and a soft area 11B02 (which may also be referred to as a second portion), and an elastic modulus of the hard area 11B01 is greater than an elastic modulus of the soft area 11B02. The hard area 11B01 is located in the first non-bending area, and the soft area 11B02 may be located in at least one of the first bending area and the second bending area.

In FIG. 18, the hard area 11B01 and the soft area 11B02 are connected to each other to form an integrated structure. In some optional manufacturing processes, a cushion layer material may be first coated on the substrate, and then area-based curing is performed on the cushion layer material through UV (ultraviolet light), to obtain cushion materials with different hardnesses. In some other optional manufacturing processes, area-based heating may be performed on the cushion layer material, to obtain portions with different elastic moduli, to obtain the hard area and the soft area.

The cushion layer 11B is divided into the hard area 11B01 and the soft area 11B02 with different elastic moduli. The hard area 11B01 is located in the first non-bending area, so that stiffness of the first non-bending area can be improved. The soft area 11B02 with a smaller elastic modulus is located in a bending area, to ensure that the bending area has good bendability.

In FIG. 18, an elastic modulus of the cushion layer 11B (which may be referred to as a third portion) located in the second non-bending area and the third non-bending area may be less than an elastic modulus of the hard area 11B01 and greater than an elastic modulus of the soft area 11B02.

In some examples, to improve stiffness of the second non-bending area and the third non-bending area, the elastic modulus of the cushion layer 11B located in the second non-bending area and the third non-bending area may be equal to the elastic modulus of the hard area 11B01.

When the elastic modulus of the cushion layer 11B located in the second non-bending area and the third non-bending area is less than the elastic modulus of the hard area 11B01 and greater than the elastic modulus of the soft area 11B02, the cushion material may be first coated. In this case, a modulus of the cushion material is low. Then, the cushion material is cross-linked through local UV curing or heating, and a portion with a low modulus and a portion with a high modulus are obtained by controlling energy of the UV or a heating temperature.

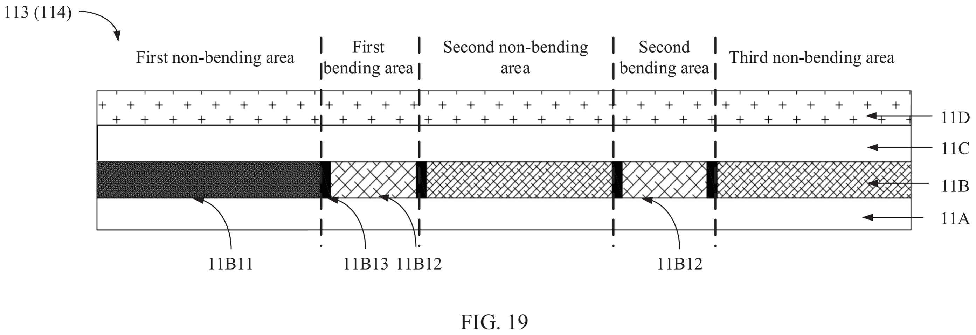

FIG. 19 is a diagram of a structure of still another display cover plate 113 or protective layer 114 according to an embodiment of this application. The substrate 11D and the cushion layer 11B are included, and the substrate 11D and the cushion layer 11B are connected to each other via the bonding layer 11C.

In this example, the cushion layer 11B includes the hard portion 11B11 with a large elastic modulus and the soft portion 11B12 with a small elastic modulus. The hard portion 11B11 and the soft portion 11B12 are spliced together. The hard portion 11B11 is located in the first non-bending area, and the soft portion 11B12 is located in at least one of the first bending area and the second bending area.

In some examples, as shown in FIG. 19, the hard portion 11B11 and the soft portion 11B12 may be spliced together via a bonding layer 11B13. For example, when the bonding layer 11C located on one side of the cushion layer 11B is coated, an adhesive may overflow into a gap between the hard portion and the soft portion, to bond the hard portion and the soft portion together.

Refer to FIG. 19. To improve stiffness of the second non-bending area and the third non-bending area, the elastic modulus of the cushion layer 11B located in the second non-bending area and the third non-bending area may be equal to the elastic modulus of the hard portion.

In some other examples, the elastic modulus of the cushion layer 11B located in the second non-bending area and the third non-bending area may be less than the elastic modulus of the hard portion and greater than an elastic modulus of the soft portion.

In the example in FIG. 19, the hard portion 11B11 may be made of at least one of polyethylene terephthalate (polyethylene terephthalate, PET), transparent polyimide (CPI), and the like. The soft portion 11B12 may be made of at least one of a thermoplastic polyurethane (TPU) elastomer, a thermoplastic polyamide elastomer (TPAE), and the like.

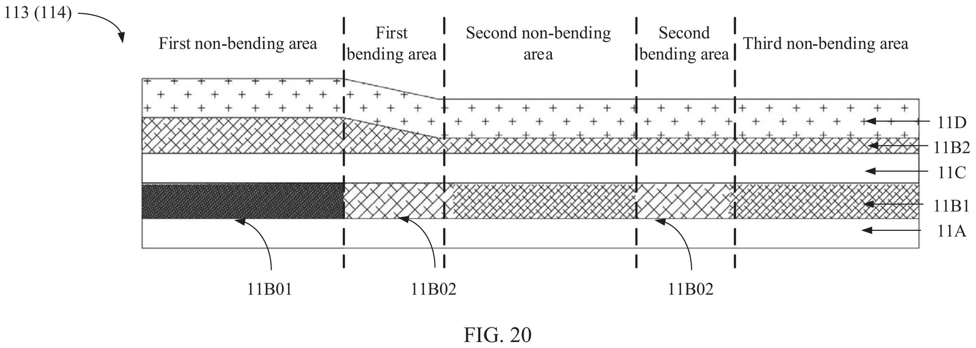

FIG. 20 is a diagram of a structure of yet still another display cover plate 113 or protective layer 114 according to an embodiment of this application. The cushion layer 11B includes the first cushion layer 11B1 and the second cushion layer 11B2. The first cushion layer 11B1 includes the hard area 11B01 with a large elastic modulus and the soft area 11B02 with a small elastic modulus. At the second cushion layer 11B2, a thickness of a portion located in the first bending area is designed to be of an unequal-thickness structure. In embodiments, an unequal-thickness design of the cushion layer is combined with a design of unequal elastic moduli.

When the display module is in the folded state and the first non-bending area is exposed, the first bending area connecting the first non-bending area and the second non-bending area needs to have a sufficient capability of resisting external force impact. For example, when an electronic device in the closed state falls, the first bending area may be damaged when being impacted by the ground and a hinge mechanism located on one side of the first bending area.

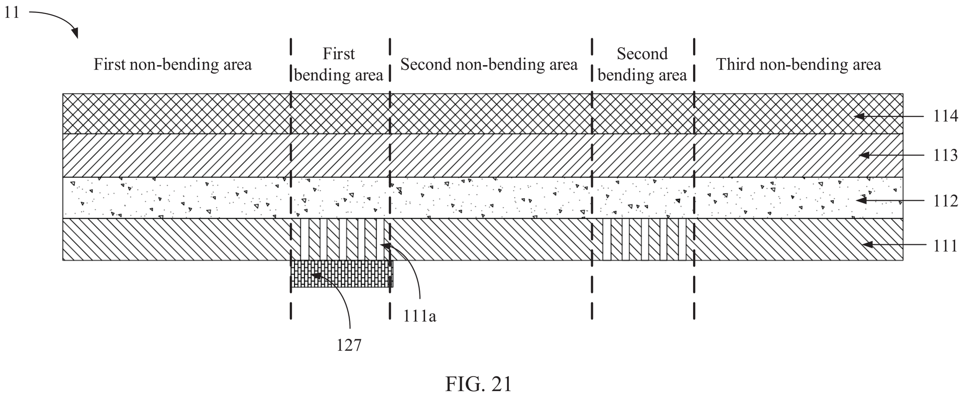

Embodiments of this application provide some new display modules 11. As shown in FIG. 21, a cushion 127 is disposed on one side that is of the support plate 111 and that is away from the display 112, and the cushion 127 is disposed at a position that is of the support plate 111 and that is opposite to the first bending area.

In some examples, to improve bendability of the support plate 111, a hollow structure 111a is provided at a portion opposite to the first bending area, and the cushion 127 is disposed at a position opposite to the hollow structure 111a.

The cushion 127 may be of a film material structure with one layer or a film material structure with more layers.

For example, the cushion 127 may be made of at least one of materials such as stainless steel (SUS), a thermoplastic polyurethane (TPU) elastomer, a porous foam (Foam) material, and a PET film material.

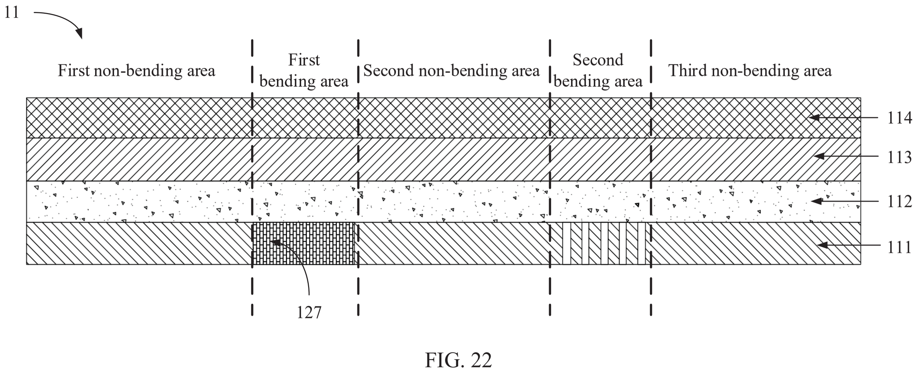

FIG. 22 is a diagram of a structure of another display module according to an embodiment of this application. In this implementation, the cushion 127 is disposed in the support plate 111. For example, a slot may be provided in the support plate 111, and the cushion 127 is disposed in the slot. The slot is located at a position opposite to the first bending area.

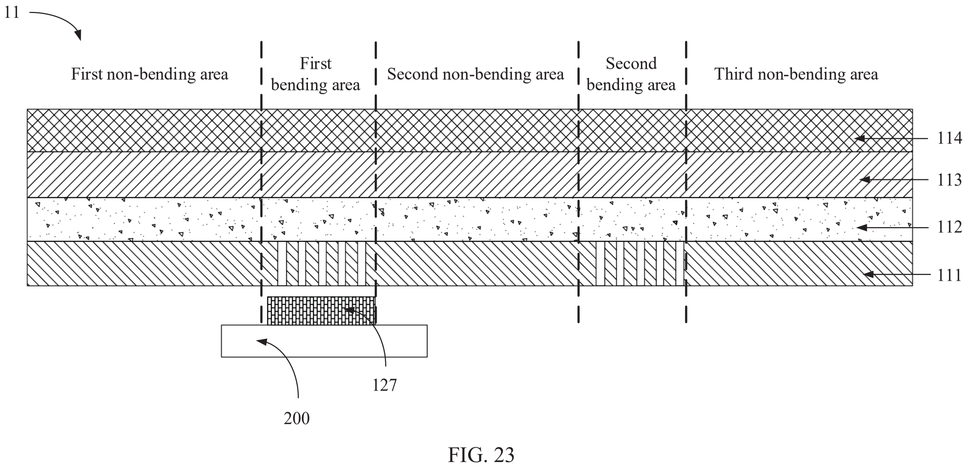

FIG. 23 is a diagram of a structure of another display module according to an embodiment of this application. In this implementation, the cushion 127 is disposed on a hinge mechanism 200 located on one side of the display module.

As shown in FIG. 21 to FIG. 23, because the cushion 127 is included, when the first bending area is impacted by an external force, a degree of damage to the display module can be reduced by using a cushioning function of the cushion 127.

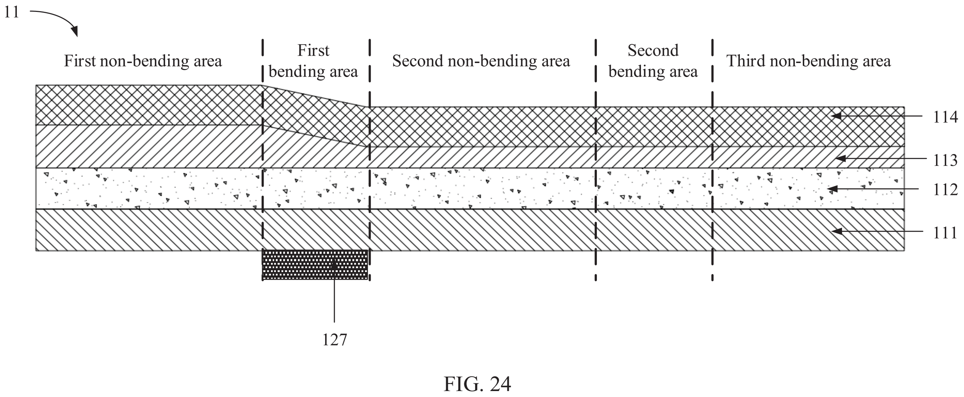

FIG. 24 is a diagram of a structure of yet still another display module according to an embodiment of this application. In this structure, the display cover plate 113 located in the first bending area is designed to be of an unequal-thickness structure, and the cushion 127 is further disposed on one side that is of the support plate 111 and that is away from the display 112. This can improve stiffness of an exposed non-bending portion, does not weaken bendability of a bending portion, can reduce a degree of damage to the bending portion of the display module, and can improve use performance of the display module.

In some other examples, areas of the protective layer 114 may be designed to be of an unequal-thickness structure.

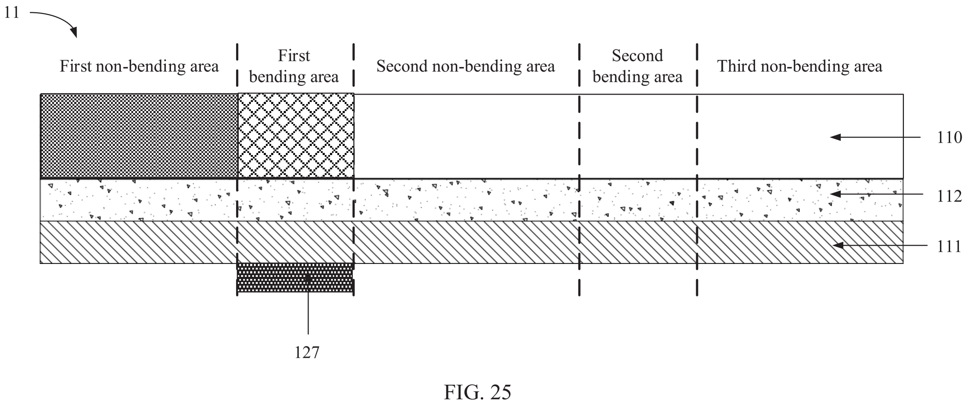

As shown in FIG. 25, the cover plate (for example, the display cover plate or the protective layer) located on the display surface of the display 112 is designed to be of a structure of unequal elastic moduli shown in FIG. 17 to FIG. 20. In addition, the cushion 127 is disposed at a position that is of the support plate 111 and that is opposite to the first bending area. This not only optimizes bendability of a bending portion of the display module, but also improves impact resistance and compression resistance performance of the bending portion.

In the descriptions of this specification, the described specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A display module, comprising:
a display; and
a cover plate, disposed on a display surface of the display, wherein the cover plate comprises a first non-bending area, a second non-bending area, a third non-bending area, a first bending area, and a second bending area; the first bending area connects the first non-bending area and the second non-bending area; the second bending area connects the second non-bending area and the third non-bending area; and both the first bending area and the second bending area are bendable along a bending line, to switch between an unfolded state and a closed state, and
a thickness of the first non-bending area is not equal to a thickness of the second non-bending area.

2. The display module according to claim 1, wherein the thickness of the first non-bending area is greater than the thickness of the second non-bending area.

3. The display module according to claim 2, wherein the cover plate comprises:
a first substrate and a first cushion layer, wherein the first cushion layer is closer to the display than the first substrate, and
a thickness of the first substrate located in the first non-bending area is greater than a thickness of the first substrate located in the second non-bending area, and/or
a thickness of the first cushion layer located in the first non-bending area is greater than a thickness of the first cushion layer located in the second non-bending area.

4. The display module according to claim 3, wherein
a thickness of the first cushion layer located in the first bending area gradually decreases in a direction from the first non-bending area to the second non-bending area.

5. The display module according to claim 3 or 4, wherein the first cushion layer is disposed on a surface that is of the first substrate and that faces the display.

6. The display module according to any one of claims 3 to 5, wherein the cover plate further comprises:
a second substrate, wherein
the second substrate is disposed between the first cushion layer and the display, and the first cushion layer is disposed on a surface that is of the second substrate and that is away from the display.

7. The display module according to any one of claims 3 to 6, wherein the cover plate further comprises:
a second cushion layer, wherein the second cushion layer comprises a first portion and a second portion, and
the first portion of the second cushion layer is located in the first non-bending area, the second portion of the second cushion layer is located in the first bending area, and an elastic modulus of the first portion of the second cushion layer is greater than an elastic modulus of the second portion of the second cushion layer.

8. The display module according to claim 7, wherein the first portion of the second cushion layer and the second portion of the second cushion layer are of an integrally formed structure; or
the first portion of the second cushion layer and the second portion of the second cushion layer are connected to each other via a bonding layer.

9. The display module according to claim 7 or 8, wherein the second cushion layer further comprises a third portion, and the third portion of the second cushion layer is located in the second non-bending area; and
an elastic modulus of the third portion of the second cushion layer is less than the elastic modulus of the first portion of the second cushion layer and greater than the elastic modulus of the second portion of the second cushion layer.

10. The display module according to any one of claims 1 to 9, wherein a thickness of the first bending area gradually decreases in the direction from the first non-bending area to the second non-bending area.

11. The display module according to any one of claims 1 to 10, wherein the thickness of the second non-bending area gradually decreases in a direction from the first bending area to the second bending area.

12. The display module according to any one of claims 1 to 11, wherein a thickness of the third non-bending area is less than the thickness of the first non-bending area.

13. The display module according to any one of claims 1 to 12, wherein the thickness of the first bending area, the thickness of the second non-bending area, a thickness of the second bending area, and the thickness of the third non-bending area gradually decrease in a direction from the first non-bending area to the third non-bending area.

14. The display module according to any one of claims 1 to 13, wherein the display module further comprises:
a support plate, wherein the support plate is disposed on one side that is of the display and that is away from the display surface; and
a cushion, wherein the cushion is disposed on one side that is of the support plate and that is away from the display, and the cushion is located at a position corresponding to the first bending area.

15. The display module according to any one of claims 1 to 13, wherein the display module further comprises:
a support plate, wherein the support plate is disposed on one side that is of the display and that is away from the display surface; and
a cushion, wherein the cushion is embedded at a position that is of the support plate and that corresponds to the first bending area.

16. The display module according to any one of claims 1 to 15, wherein when the first bending area is in the closed state, the display surface of the display is away from a center of an arc-shaped structure formed by the display module, relative to a back surface of the display.

17. A display module, comprising:
a display; and
a cover plate, disposed on a display surface of the display, wherein the cover plate comprises a first non-bending area, a second non-bending area, a third non-bending area, a first bending area, and a second bending area; the first bending area connects the first non-bending area and the second non-bending area; the second bending area connects the second non-bending area and the third non-bending area; and both the first bending area and the second bending area are bendable along a bending line, to switch between an unfolded state and a closed state, and
an elastic modulus of the first non-bending area is not equal to an elastic modulus of the first bending area.

18. The display module according to claim 17, wherein the elastic modulus of the first non-bending area is greater than the elastic modulus of the first bending area.

19. The display module according to claim 18, wherein the cover plate comprises:
a substrate and a cushion layer, wherein the cushion layer is closer to the display than the substrate,
the cushion layer comprises a first portion and a second portion, and
the first portion of the cushion layer is located in the first non-bending area, the second portion of the cushion layer is located in the first bending area, and an elastic modulus of the first portion of the cushion layer is greater than an elastic modulus of the second portion of the cushion layer.

20. The display module according to claim 19, wherein
the first portion of the cushion layer and the second portion of the cushion layer are of an integrally formed structure; or
the first portion of the cushion layer and the second portion of the cushion layer are connected to each other via a bonding layer.

21. The display module according to claim 19 or 20, wherein
the cushion layer further comprises a third portion, and the third portion of the cushion layer is located in the second non-bending area; and
an elastic modulus of the third portion of the cushion layer is less than the elastic modulus of the first portion of the cushion layer and greater than the elastic modulus of the second portion of the cushion layer.

22. The display module according to any one of claims 17 to 21, wherein the display module further comprises:
a support plate, wherein the support plate is disposed on one side that is of the display and that is away from the display surface; and
a cushion, wherein the cushion is disposed on one side that is of the support plate and that is away from the display, and the cushion is located at a position corresponding to the first bending area.

23. The display module according to any one of claims 17 to 21, wherein the display module further comprises:
a support plate, wherein the support plate is disposed on one side that is of the display and that is away from the display surface; and
a cushion, wherein the cushion is embedded at a position that is of the support plate and that corresponds to the first bending area.

24. The display module according to any one of claims 17 to 23, wherein when the first bending area is in the closed state, the display surface of the display is away from a center of an arc-shaped structure formed by the display module, relative to a back surface of the display.

25. An electronic device, comprising:
a housing; and
the display module according to any one of claims 1 to 24, wherein
the display module is disposed on the housing.
